# EUROPEAN PATENT APPLICATION

(11) **EP 3 503 215 A1**
(43) Date of publication of application: **26.06.2019**
(21) Application number: 18179908.1
(22) Date of filing: 26.06.2018
(51) Int. Cl.: H01L 31/049

(54) **SOLAR PANEL**

(30) Priority: 25.12.2017 CN 201721835949 U
(71) Applicant: Miasole Photovoltaic Technology Co., Ltd., Beijing (CN)
(72) Inventor: HUANG, Xu, BEIJING (CN)
(74) Representative: Cabinet Beau de Loménie

(57) **Abstract**

The present disclosure relates to a solar panel, including a frosted protective film (100), an adhesive layer (200), a water blocking film (300), a front package film (400), a thin film battery chip (500), a rear package film (600), and a back plate (700) which are sequentially laminated.

## Description

### TECHNICAL FIELD

The present disclosure relates to the technical field of solar power generation, and in particular, to a solar panel.

### BACKGROUND

With the rapid development of solar power generation technologies, the solar power generation technologies have been used in more and more products. The solar panels are devices that use the solar energy to generate electricity and typically include crystalline silicon solar panels and thin film solar panels. At present, some solar panels are often seen in public places such as advertising billboards, and bus platforms. However, various advertising leaflets, stickers, etc. are often affixed on these panels, which seriously affect a light transmittance of the solar panels, thereby greatly affecting power of the solar panels and also affecting an appearance of the city. When cleaning up these stickers or leaflets, people usually scrapes these stickers or leaflets by using a knife, which may easily damage the solar panels. Such cleaning method can not only increase the labor costs, but also easily bring out additional maintenance costs of the solar panel.

The solar panels currently on the market simply solve the problem of outdoor charging by sunlight, or are only used to achieve the function of generating and storing energy, but cannot give the user healthier and more environmentally friendly user experience. In particular, the small advertisements are indiscriminately posted and cannot be cleaned, affecting the user experience and reducing the power.

### SUMMARY

An objective of the present disclosure is to provide a solar panel, so as to avoid adhesion of stickers or advertising leaflets on a surface of the solar panel and improve a power generation performance of the solar panel.

An embodiment of the present disclosure provides a solar panel, including: a frosted protective film, an adhesive layer, a water blocking film, a front package film, a thin film battery chip, a rear package film, and a back plate which are sequentially laminated.

In the solar panel, the frosted protective film is provided with a granular structure on a plane where light is received.

In the solar panel, the frosted protective film is provided with a trench structure on a plane where light is received.

In the solar panel, the adhesive layer is an EVA hot melt adhesive film.

In the solar panel, each of the front package film and the rear package film is one of an EVA film, a POE film, or a PVB film.

In the solar panel, the front and rear package films are both POE films.

In the solar panel, the thin film battery chip is one of a copper indium gallium selenide solar photovoltaic chip, a copper indium selenide solar photovoltaic chip, a cadmium telluride solar photovoltaic chip, and a dye-sensitized solar photovoltaic chip.

In the solar panel, the thin film battery chip is the copper indium gallium selenide solar photovoltaic chip.

In the solar panel, the frosted protective film has a thickness ranging from 380 um to 420 um, and the water blocking film has a thickness ranging from 0.1 mm to 0.3 mm.

In the solar panel, the back plate is a fiberboard, and the back plate has a thickness ranging from 0.3 mm to 1 mm.

In the solar panel provided by the embodiments of the present disclosure, a frosted protective film is provided on an outermost layer of the solar panel. The frosted protective film has a relatively rough surface, and thus it is not easy to attach an advertising sticker on a surface of the frosted protective film. And, with uneven surface characteristics of the rough surface, there is a small adhesion area between the sticker and the frosted protective film, and the adhesive force is small, thereby facilitating the cleaning of the sticker. In addition, by placing a water blocking film on a side close to the frosted protective film, moisture penetration from the side of the frosted protective film can be effectively blocked, and at the same time, by providing a back plate at a side away from the frosted protective film, water vapor penetration from the back plate can be prevented. Accordingly, the present disclosure can solve the problem of water vapor penetration into the solar panel, improve the performance of the solar panel, and prolong a service life of the battery chip.

### BRIEF DESCRIPTION OF THE DRAWINGS

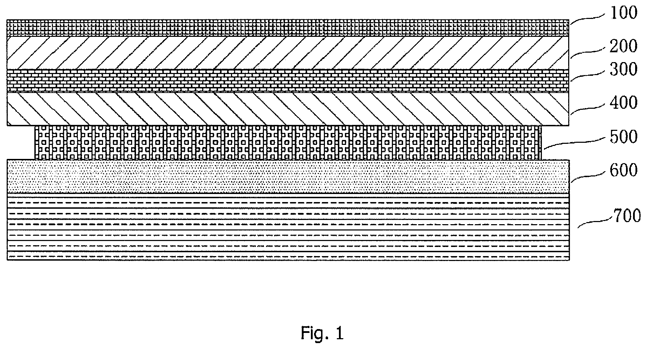

Fig. 1 is a schematic diagram showing a solar panel according to an embodiment of the present disclosure.

### DETAILED DESCRIPTION

Embodiments of the present disclosure are described in detail below, examples of which are illustrated in the accompanying drawings, in which the same or similar reference signs denote the same or similar elements or elements having the same or similar functions throughout. The embodiments described below with reference to the drawings are exemplary, are used only to explain the present disclosure, and cannot be construed as limiting the present disclosure.

As shown in Fig. 1, an embodiment of the present disclosure provides a solar panel, which includes: a frosted protective film 100, an adhesive layer 200, a water blocking film 300, a front package film 400, a thin film battery chip 500, a rear package film 600, and a back plate 700 which are sequentially laminated. The frosted protective film is provided on an outermost layer of the solar panel. Since the frosted protective film has a relatively rough surface, it is not easy to attach a sticker to the surface of the frosted protective film. And, the rough surface has an uneven surface characteristic, there will be many gaps between the sticker and the frosted protective film, that is, there is a relatively small adhesive area between the sticker and the frosted protective film, and an adhesive force is small, thereby facilitating the cleaning of the sticker.

Specifically, in one embodiment, the frosted protective film may be provided with a granular structure on a side of the frosted protective film which receives light, that is, a gap is maintained between the particles, and the particles may be evenly dispersed on the surface of the frosted protective film.

In another embodiment, the frosted protective film is provided with a trench structure on a side of the frosted protective film which receives light. The trench structure may be formed by strip-shaped protrusions and strip-shaped grooves which are arranged alternately. When the advertising sticker is adhered onto the trench structure, the advertising sticker can only be in contact with the strip-shaped protrusions, and cannot be in contact with the strip-shaped grooves, that is, a gap is formed between the advertising sticker and the strip-shaped grooves, the adhesive area between the advertising sticker and the frosted protective film is reduced, the adhesive force is reduced, and thus it is not easy to attach the advertising sticker.

It should be noted that since the solar panels in public places are usually exposed outdoors for a long time, the solar panels are vulnerable to moisture, resulting in too fast degradation of the performance of the battery chips in the solar panels. Therefore, in order to solve the above problem, in the present embodiment, a water blocking film 300 is placed on a side close to the frosted protective film 100. In this way, moisture penetration from the side of the frosted protective film 100 can be effectively blocked. Meanwhile, a back plate 700 is disposed on a side away from the frosted protective film 100. In this way, moisture penetration from the side of the back plate 700 can be prevented. Therefore, the problem of water vapor penetration into the solar panel is effectively solved, the performance of the solar panel is improved, and the service life of the battery chip is prolonged.

Specifically, the frosted protective film 100 may be a flexible thin film material having a certain light transmission, weather resistance, insulation, and high water resistance, and may be one of ETFE (ethylene-tetra-fluoro-ethylene), PVC (polyvinyl chloride), PTFE (polytetrafluoroethylene), and PET (polyethylene terephthalate). In the present embodiment, the frosted protective film 100 may be a PET frosted film.

In addition, the adhesive layer 200 may be a film with certain anti-UV, anti-aging and high-adhesion properties. In the present embodiment, the adhesive layer 200 may be an EVA (ethylene-vinyl acetate copolymer) hot melt adhesive film. The EVA hot melt adhesive film has a strong adhesive force and durability, and may firmly connect the PET frosted film and the water blocking film 300, and may also resist high temperature, moisture and ultraviolet rays.

Specifically, the front package film 400 and the rear package film 600 have a certain adhesive strength. The function of the adhesive strength is to ensure that both the frosted protective film 100 and the back plate 700 can be adhered to the flexible thin film battery chip 500 securely and reliably and prevent the influences of the external environment on the performance of the flexible thin film battery chip 500. At the same time, the front package film 400 and the rear package film 600 also have a relatively high light transmission performance to improve the power generation performance and conversion efficiency of the flexible thin film battery chip 500. Specifically, both the front package film 400 and the rear package film 600 may be one of an EVA film, a POE film, and a PVB film. In the present embodiment, the front package film 400 and the rear package film 600 may be a POE film. The POE film is a copolymer of ethylene and octene. The POE film is a saturated aliphatic chain structure, has relatively few tertiary carbon atoms in the molecular chain, shows a good weather resistance performance, a UV aging resistance performance, an excellent heat resistance performance, and a low temperature resistance performance, and thus the POE film has a better aging resistance than the EVA film. The front package film 400 and the rear package film 600 may also be other materials having the above properties, which are not limited by the embodiments of the present disclosure.

Specifically, the thin film battery chip 500 may be one of a copper indium gallium selenide solar photovoltaic chip, a copper indium selenide solar photovoltaic chip, a cadmium telluride solar photovoltaic chip, and a dye-sensitized solar photovoltaic chip. In order to enhance a light absorption capability of the thin film battery chip 500, improve the photoelectric conversion efficiency and power generation stability of the thin film battery chip 500, the thin film battery chip 500 may be a flexible copper indium gallium selenide solar photovoltaic chip.

Specifically, in order to enhance the waterproof property of the solar panel and prolong the service life of the solar panel, the back plate 700 may be a fiberboard. The thickness of the back panel 700 may range from 0.3 mm to 1 mm. In one example, the thickness of the back panel 700 is 0.8mm.

In order to effectively prevent water vapor from penetrating from the side of the frosted protective film 100, the thickness of the frosted protective film 100 may range from 380 um to 420 um, and the thickness of the water blocking film 300 may range from 0.1 mm to 0.3 mm. If the thickness of the frosted protective film 100 is too large, the permeability of the solar panel will be degraded, and if the thickness of the frosted protective film 100 is too small, the waterproof performance will be reduced. Therefore, in the present embodiment, the thickness value of the frosted protective film 100 is 400 um, and the thickness value of the water blocking film 300 is 0.2 mm.

Those skilled in the art can understand that, in order to clearly show the structure of each layer of the solar panel, the thickness of each layer in Fig. 1 is not drawn to scale.

In the solar panel provided by the embodiments of the present disclosure, a frosted protective film is provided on an outermost layer of the solar panel. The frosted protective film has a relatively rough surface, and thus it is not easy to attach an advertising sticker on a surface of the frosted protective film. And, with uneven surface characteristics of the rough surface, there is a small adhesion area between the sticker and the frosted protective film, and the adhesive force is small, thereby facilitating the cleaning of the sticker. In addition, by placing a water blocking film on a side close to the frosted protective film, moisture penetration from the side of the frosted protective film can be effectively blocked, and at the same time, by providing a back plate at a side away from the frosted protective film, water vapor penetration from the back plate can be prevented. Accordingly, the present disclosure can solve the problem of water vapor penetration into the solar panel, improve the performance of the solar panel, and prolong a service life of the battery chip.

The solar panel according to the embodiment of the present disclosure can integrate solar energy, energy storage and environmental protection. The frosted protective layer can prevent urban advertising from being affixed on the solar panel and facilitate cleaning. The frosted protective layer has a relatively high light transmittance, thereby not affecting the power of the solar panel. It is possible to better solve the problems of city psoriasis faced by the users in public places and the decrease of the power of the solar panels. It can also provide the users with a better living, entertainment and clean consumption environment.

The solar panel according to the embodiments of the present disclosure integrates solar power generation, energy storage, charging, clean and environmental protection, may have functions such as energy storage, charging, clean, environmental protection and no pollution, and is applicable to application scenes in many public places, such as business trips, tourism, and outdoor sports.

The above embodiments illustrate the configuration, features, and effects of the present disclosure in detail. The foregoing descriptions are merely exemplary embodiments of the present disclosure, and the implementation scope of the present disclosure is not limited by the drawings. Any changes made according to the concept of the present disclosure or equivalent modifications without departing from the spirit covered by the description and diagram, shall be within the scope of this disclosure.

## Claims

1. A solar panel, comprising: a frosted protective film (100), an adhesive layer (200), a water blocking film (300), a front package film (400), a thin film battery chip (500), a rear package film (600), and a back plate (700) which are sequentially laminated.

2. The solar panel according to claim 1, wherein the frosted protective film (100) is provided with a granular structure on a plane where light is received.

3. The solar panel according to claim 1, wherein the frosted protective film (100) is provided with a trench structure on a plane where light is received.

4. The solar panel according to anyone of claims 1 to 3, wherein the adhesive layer (200) is an EVA hot melt adhesive film.

5. The solar panel according to anyone of claims 1 to 4, wherein each of the front package film (400) and the rear package film (600) is one of an EVA film, a POE film, or a PVB film.

6. The solar panel according to claim 5, wherein the front and rear package films (400, 600) are both POE films.

7. The solar panel according to anyone of claims 1 to 6, wherein the thin film battery chip (500) is one of a copper indium gallium selenide solar photovoltaic chip, a copper indium selenide solar photovoltaic chip, a cadmium telluride solar photovoltaic chip, and a dye-sensitized solar photovoltaic chip.

8. The solar panel according to claim 7, wherein the thin film battery chip (500) is the copper indium gallium selenide solar photovoltaic chip.

9. The solar panel according to anyone of claims 1 to 8, wherein the frosted protective film (100) has a thickness ranging from 380 um to 420 um, and the water blocking film (300) has a thickness ranging from 0.1 mm to 0.3 mm.

10. The solar panel according to anyone of claims 1 to 9, wherein the back plate (700) is a fiberboard, and the back plate (700) has a thickness ranging from 0.3 mm to 1 mm.

11. The solar panel according to claim 3, wherein the trench structure is formed by strip-shaped protrusions and strip-shaped grooves arranged alternately.

12. The solar panel according to claim 1, wherein the frosted protective film (100) is one of an ETFE, a PVC, a PTFE, and a PET.

13. The solar panel according to claim 9, wherein the thickness of the frosted protective film (100) is 400 um, and the thickness of the water blocking film (300) is 0.2 mm.
